# EUROPÄISCHE PATENTANMELDUNG

(11) **EP 1 593 972 A1**
(43) Veröffentlichungstag der Anmeldung: **09.11.2005**
(21) Anmeldenummer: 05007243.8
(22) Anmeldetag: 02.04.2005
(51) Int. Cl.: G01R 11/04, G01R 11/24, G01R 1/04

(54) **Stromzählereinrichtung**

(30) Priorität: 05.05.2004 DE 102004022125
(71) Anmelder: ABB PATENT GmbH, 68526 Ladenburg (DE)
(72) Erfinder: Eppe, Klaus-Peter, Dipl.-Ing., 69429 Waldbrunn (DE); Wieland, Ralf, Dipl.-Ing., 69429 Waldbrunn (DE); Popa, Heinz-Erich, Dr.-Ing., 69245 Bammental (DE)
(74) Vertreter: Miller, Toivo

(57) **Zusammenfassung**

Die Erfindung betrifft eine Zählerplattform zum Aufsetzen eines Haushaltszählers, insbesondere eines elektronischen Haushaltszählers, mit einer Trägerplatte (18), auf die der Haushaltszähler aufgesetzt ist und durch die hindurch Kontaktfahnen (13, 14) des Haushaltszählers zu Kontaktstücken (16, 17; 50, 51; 115) sowie Haltekrallen (20, 21) in die Zählerplattform einführbar sind, wobei bei der Montage in die Betriebsstellung und aus dieser heraus die zu jeder Phase gehörenden Kontaktstücke (16, 17; 50, 51; 115) mittels einer verschiebbaren Brücke (35) verbunden und voneinander getrennt werden. Zwischen der Trägerplatte (18) und den Kontaktstücken (16, 17; 50, 51; 115) ist eine mit der Anzahl und Anordnung der Kontaktfahnen (13, 14) am Zähler entsprechende Anzahl und Anordnung von Schlitzen (21, 22; 31, 32; 112) versehende, nur mittels eines Werkzeuges verschiebbare Platte vorgesehen, an der Vorsprünge (33) angeformt sind, die in Aussparungen (34; 82) der Brücken (35) eingreifen, wobei erst nach Aufsetzen des Zählers die Platte mittels des Werkzeuges verschoben wird, so dass zunächst die Schlitze (21, 22; 31, 32; 112) in der Platte unter die Kontaktfahnen (13, 14) des Zählers und bei weiterer Verschiebung der Platte der Zähler in seine Betriebsstellung gelangen.

## Beschreibung

Die Erfindung betrifft eine Stromzählereinrichtung gemäß dem Oberbegriff des Anspruches 1.

In einer elektrischen Installationsanlage, beispielsweise in einer Hausinstallationsanlage befindet sich wenigstens ein Zählerplatz, in dem wenigstens ein Haushaltsstromzähler installiert ist, über den der von dem Energieversorgungsunternehmen gelieferte Strom zu den Verbrauchern geführt wird, so dass die Menge des abgenommenen Stromes erfasst werden kann. Der Haushaltsstromzähler wird dabei auf ein sogenanntes Zählerkreuz am Zählerplatz montiert, was aufwendig ist.

Im Zuge der weiteren Entwicklung soll der Zähler auf einfachste Weise montiert werden können, was gemäß der DE 100 52 998 dadurch erfolgt, dass der Zähler mit seinen an seiner Bodenseite befindlichen Anschlusskontaktstiften ins Innere einer Zählerplattform eingeführt und dann in seine endgültige Stellung, d. h. in seine Betriebsstellung, durch Verschieben überführt wird. Dieser Verschiebevorgang erfolgt parallel zu einer Trägerplatte an der Zählerplattform.

Der in der DE 100 52 998 beschriebene Zähler ist ein elektronischer Haushaltszähler, auf den die Zählerplattform angepasst ist. Bei einer Neuinstallation wird der Zählerplatz fabrikseitig auf den Zähler angepasst; bei Nachrüstungen wird in zweckmäßiger Weise am Zählerplatz ein Adapter angebracht, der dann als Zählerplattform dient, auf die der Zähler aufgesetzt wird.

In der DE 10 2004 001 453 ist eine Stromzählereinrichtung beschrieben, bei der unterhalb der Zählerplattform Kontaktstücke vorgesehen sind, die als U-förmige Kontakttulpen ausgebildet sind. Diese Kontakttulpen sind so innerhalb der Plattform eingebaut, dass die Schenkel zweier zu einer Phase gehöriger Kontakttulpen miteinander fluchten. Zwischen den Kontaktstücken ist eine Brücke hin- und herverschiebbar geführt, wodurch einerseits eine Überbrückung der Kontaktstücke und andererseits eine Unterbrechung des Stromflusses zwischen den Kontaktstücken erreicht werden.

Wenn ein Zähleraustausch erfolgen soll, dann soll während der Austauschzeit eine Stromunterbrechung zum Verbraucher vermieden werden. Aus diesem Grunde sind die Brücken vorgesehen, die so bewegt werden, dass bei der Demontage, bevor die Anschlussfahnen am Zähler von den zugehörigen Kontaktstücken freikommen, die Brücken die beiden zusammengehörenden Kontaktstücke überbrücken, wodurch der Strom sowohl über den Zähler als auch über die Brücken fließt und eine zeitweise Überlappung des Stromflusses bewirkt wird. Sobald der Zähler demontiert ist, fließt der Strom nur über die Brücken, weswegen der Strom nicht mehr gezählt wird. Bei der Montage wird der Zähler auf die Zählerplattform aufgesetzt; die Kontaktfahnen am Zähler greifen in die Brücken ein, verschieben diese, wobei die Brücken solange noch die Kontaktstücke miteinander verbinden, bis die Kontaktfahnen am Zähler in die zugehörigen Kontaktstücke eingreifen; auch hierbei fließt der Strom zeitweise über die Brücken und den Zähler, bis der Zähler in seine endgültige Betriebsstellung verschoben ist und sich die Brücken in Trennstellung befinden.

Das Problem des Schutzes gemäß IP 3X ist bis jetzt noch nicht angesprochen worden.

Nach dieser Vorschrift, die Teil der DIN 40050 ist, soll der Zugang zu spannungsführenden Teilen mit einem Prüffinger, dessen Durchmesser größer als 2,5 mm ist, verhindert werden.

Diese Aufgabe wird erfindungsgemäß durch die Merkmale des Anspruches 1 gelöst.

Erfindungsgemäß befindet sich zwischen der Trägerplatte und den Kontaktstücken eine mit der Anzahl und Anordnung der Kontaktfahnen am Zähler entsprechende Anzahl und Anordnung von Schlitzen versehene, nur mittels eines Werkzeugs verschiebbare Platte vorgesehen ist, wobei erst nach Aufsetzen des Zählers die Platte mittels des Werkzeuges verschoben wird, so dass zunächst die Fahnen in die Schlitze und bei weiterem Verschieben der Platte der Zähler in seine Betriebsstellung gelangen.

Im sogenannten jungfräulichen Zustand, also im Anlieferungszustand, liegt die Platte bezogen auf die Trägerplatte so, dass die Platte die Schlitze in der Trägerplatte abdeckt. Sodann wird der Zähler aufgesetzt und mittels des Werkzeuges die Platte verschoben, bis die in der Platte befindlichen Schlitze unter die Kontaktfahnen des Zählers gelangen. Danach gleiten die Kontaktfahnen durch die Schlitze hindurch und durch weiteres Verschieben der Platte mittels des Werkzeuges werden die Platte sowie der Zähler in ihre End- oder Betriebsstellung verbracht.

Gemäß einer ersten Ausführungsform ist die Breite der Kontaktstücke in Verschieberichtung der Brücken so bemessen, dass die Kontaktfahnen nach Einlaufen in die Schlitze mit den zugehörigen Kontaktstücken in elektrisch leitende Verbindung gelangen.

Dabei können die Kontaktstücke wenigstens einen Schlitz aufweisen, so dass jedes Kontaktstück wenigstens ein Schenkelpaar aufweist. In zweckmäßiger Weise wird jeder Schenkel der Kontaktstücke geschlitzt, so dass jedes Kontaktstück zwei Schenkelpaare besitzt.

Beim Montieren gleiten die Kontaktfahnen zwischen eines der beiden Schenkelpaare und danach in das in Schieberichtung hintere Schenkelpaar. Dadurch wird erreicht, dass eine korrekte Kontaktierung auch dann gegeben ist, wenn ein Kontaktstück oder eine Kontaktfahne nicht exakt eingebaut ist.

Bei einer weiteren Ausführungsform sind die Kontaktstücke so bemessen, dass die Kontaktfahnen, nachdem sie durch die Schlitze hindurch geglitten sind, zunächst nicht mit den Kontaktstücken in elektrisch leitende Berührung gelangen, sondern erst beim weiteren Verschieben.

Weitere vorteilhafte Ausgestaltungen und Verbesserungen der Erfindung sind den weiteren Unteransprüchen zu entnehmen.

Anhand der Zeichnung, in der einige Ausführungsbeispiele der Erfindung dargestellt sind, sollen die Erfindung sowie weitere vorteilhafte Ausgestaltungen und Verbesserungen und weitere Vorteile näher erläutert und beschrieben werden.

### Es zeigen:

- Fig. 1: eine Seitenansicht auf eine Stromzählereinrichtung, mit aufgeschnittenem Adaptergehäuse,
- Fig. 2: die Einzelheit gemäß A der Fig. 1, in der der dortige Teil vergrößert dargestellt ist, in einer ersten Stellung,
- Fig. 3 und 4: die Einrichtung gemäß Fig. 2 in einer Mittelstellung und einer Endstellung,
- Fig. 5: eine weiter Ausführungsform der Erfindung, ebenfalls in vergrößerter Darstellung, ähnlich wie die Darstellung gemäß Fig. 2,
- Fig. 6 und 7: die Einrichtung gemäß Fig. 5 in der Mittel- bzw. Endstellung,
- Fig. 8 bis 10: ein Antrieb für die Platte in unterschiedlichen Stellungen,
- Fig. 11 bis 14: eine andere Ausführungsform der Betätigung, in Anfangs- und Endstellung,
- Fig. 15 und 16: zwei unterschiedliche Ansichten der Kontaktstücke innerhalb des Adapters und
- Fig. 17: eine Aufsicht auf das Kontaktstück gemäß Figuren 16, 17 im nicht belasteten Zustand.

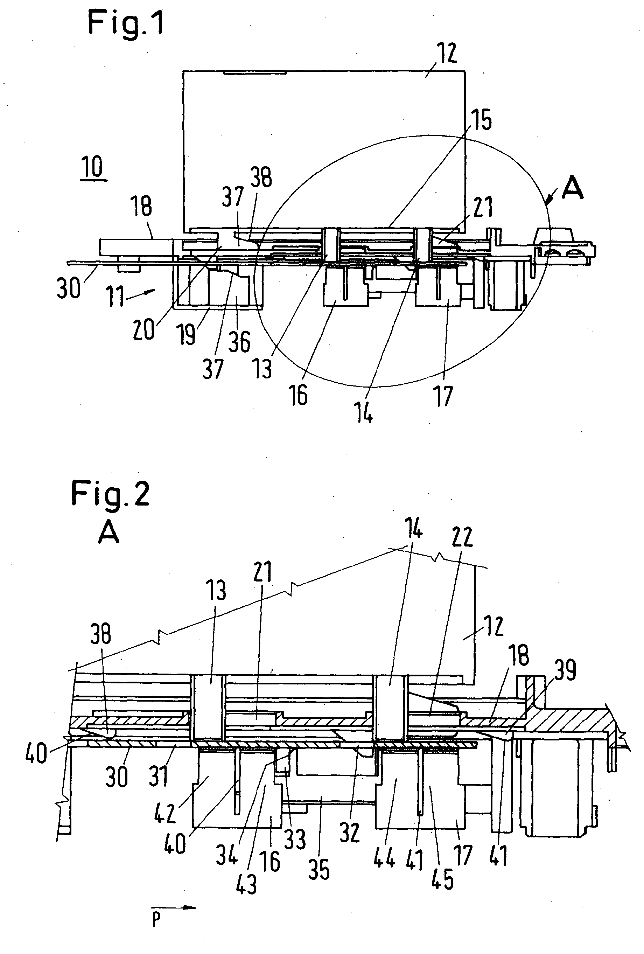

Es sei nun Bezug genommen auf die Fig. 1.

Diese zeigt eine Stromzählereinrichtung 10 mit einem strichliert dargestellten Adaptergehäuse 11, in dem sich weiter unten beschriebene Komponenten befinden, und mit einem Stromzähler 12, der ein elektronischer Stromzähler sein kann.

Am Stromzähler befinden sich Kontaktfahnen 13 und 14, die von der Bodenfläche 15 aus senkrecht vorstehen, wobei die eine Kontaktfahne, beispielsweise die Kontaktfahne 14 zur Stromzuführung und die Kontaktfahne 13 zur Stromabführung in den Zähler bzw. aus diesem heraus dienen. Weitere Kontaktfahnenpaare, die entsprechend der Anzahl der Phasen vorhanden sind, sind in Fig. 1 nicht dargestellt. Ebenfalls nicht dargestellt ist auch eine Kontaktfahne für den Neutralleiter.

Innerhalb des Adapters bzw. des Adaptergehäuses 11 befinden sich den Kontaktfahnen 13 und 14 zugehörige Kontaktstücke 16 und 17, die, wie weiter unten dargestellt sind, mit den Kontaktfahnen 13 und 14 bei der Montage in Berührung gelangen.

Das Gehäuse 11 besitzt eine Trägerplatte 18, mit dem das lediglich teilweise dargestellte Gehäuseunterteil 19 abgedeckt ist.

An der Unterseite 15 besitzt der Zähler 12 L-förmige Füße 20 und 21, von denen jeweils vier vorhanden sind, von denen lediglich die Füße 20 und 21 sichtbar sind. Diese Füße dienen als Haltekrallen, wie weiter unten näher erläutert wird.

Es sei nun Bezug genommen auf die Fig. 2.

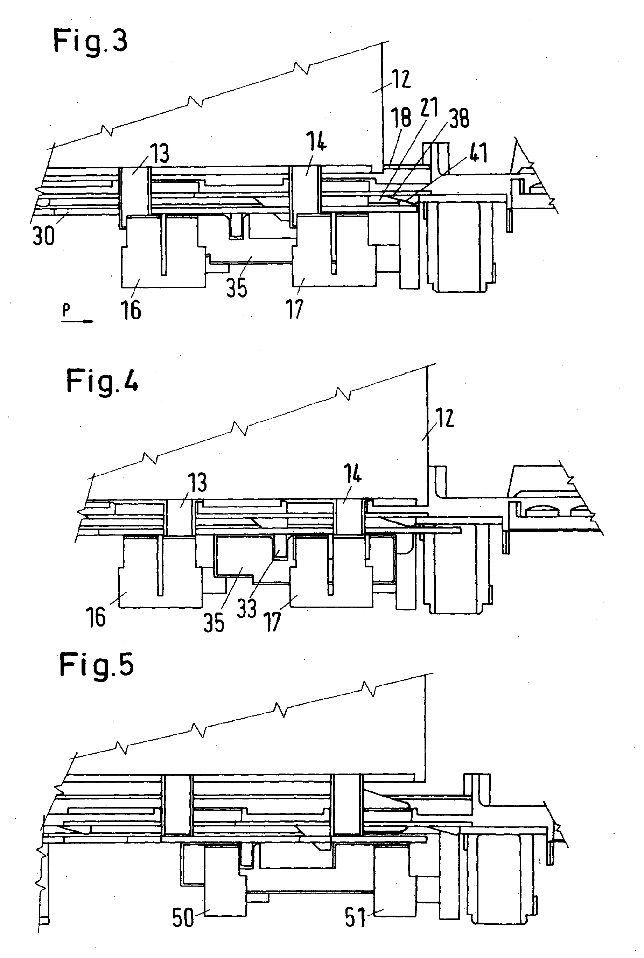

Dort ist der Teil A der Fig. 1 vergrößert dargestellt. Die Trägerplatte 18 besitzt eine der Anzahl der Kontaktfahnen 13 und 14 entsprechende Anzahl von Schlitzen 21, 22, durch die die Kontaktfahnen 13, 14 des Zählers 12 bei Beginn der Montage hindurch gesteckt werden. Die Schlitze 21, 22, durch die die Kontaktfahnen hindurch gesteckt werden, besitzen eine Länge, die dem Weg des Zählers vom Aufsetzen auf den Adapter bis in die Betriebsstellung entspricht. Damit können die Kontaktfahnen 13, 14 in den Schlitzen 21, 22 gleiten. Gleichzeitig greifen die Haltekrallen 20, 21 in entsprechende Schlitze in der Trägerplatte 18 ein, wie dies beispielsweise der DE 10 2004 003 050 dargestellt ist. Unterhalb der Trägerplatte 18 befindet sich eine Platte 30, die ebenfalls eine der Anzahl der Anschlussfahnen 13, 14 entsprechende Anzahl von Schlitzen 31 und 32 aufweist, wobei die Abmessungen der Schlitze den Abmessungen der Kontaktfahnen 13, 14 angepasst sind. Im Gegensatz zu den Schlitzen 21, 22, die eine Verschiebung des Zählers 12 gestatten und demgemäss bemessen sind, sind die Schlitze 31, 32 nur so lang, wie die Kontaktfahnen 13, 14 breit sind, gemessen in der durch die Kontaktfahnen 13, 14 aufgespannten Ebene. An der den Kontaktstücken 16, 17 zugewandten Seite besitzt die Platte 30 zapfenartige Vorsprünge 33, die in eine Aussparung 34 an einer Brücke 35 eingreifen. Die Brücke verbindet in der in Fig. 2 dargestellten Anfangsstellung die beiden Kontaktstücke 16 und 17 miteinander. Beim Verschieben der Platte 30 in Pfeilrichtung P gelangen die Schlitze 31, 32 unter die Kontaktfahnen 14, so dass die Kontaktfahnen, wie aus der Fig. 3 ersichtlich ist, durch die Platte 30 hindurchgreifen können. Mit dem Verschieben der Platte 30 wird über den Zapfen 33 auch die Brücke 35 verschoben. Wenn die Kontaktfahnen 13, 14 durch die Schlitze 31, 32 hindurchgleiten, setzen sich die Haltekrallen auf eine der Anzahl der Haltekrallen entsprechende Anzahl von Stützen 36 auf, die eine Schrägfläche 37 aufweisen, auf der die Füße bzw. Haltekrallen bei weiterem Verschieben der Platte 30 mit dem Zähler 12 nach unten, also Richtung Kontaktstücken, abgleiten.

In der Fig. 1 sind Kontaktstücke, Kontaktfahnen und Brücke lediglich für eine Phase gezeichnet; selbstverständlich sind so viele Kontaktstücke, Brücken und Kontaktfahnen vorgesehen, wie sie der Phasenanzahl entsprechen. Durch das Verschieben der Platte 30 wird der Vorteil erreicht, dass alle Brücken gleichzeitig und Synchron verschoben werden.

Die Haltekrallen 20 besitzen eine L-Form, wobei der freie Schenkel 37 jeder Haltekralle 20, 21 (nur hier in der Fig. 1 an der Haltekralle 20 demonstriert) deren zur Bodenfläche 15 hinweisenden Kante 38 abgeschrägt ist.

Die Fig. 3 zeigt die Stellung, in der die Kontaktfahnen 13, 14 in die Kontaktstücke 16, 17 hineingleiten; die Brücke 35 ist, wie ersichtlich in der Fig. 3, verschoben, wobei zwischen den Kontaktstücken 16 und 17 und der Brücke 35 noch eine elektrisch leitende Verbindung besteht, so dass Stromfluss sowohl über die Brücke 35 als auch über den Zähler 12 zu dem Verbraucher vorhanden ist.

An der den Kontaktstücken zugewandten Seite der Trägerplatte sind Nasen 38, 39 vorgesehen, die eine der Kante 38 entsprechende Schrägfläche 40, 41 aufweisen. In Fig. 3 ist dargestellt, dass die Haltekrallen, zu sehen ist lediglich die Haltekralle 21, mit ihrer Kante 38 auf die Schrägfläche 41 gerade auf läuft, und bei weiterem Verschieben in Pfeilrichtung P wird der Zähler 12 senkrecht zur Trägerplatte 18 in den Adapter 11 hineingezogen, wobei die Haltekrallen sowohl auf den Schrägflächen 41 als auch auf den Schrägflächen 37 auf- bzw. abgleiten. Dies ist in der DE 10 2004 003 050 dargestellt.

Wenn der Zähler 12 seine Endstellung erreicht hat, dann sind die Kontaktfahnen 13 und 14 vollständig in die Kontaktstücke 16 und 17 eingetaucht, wobei sich die Brücke 35 von dem in der Fig. 4 links befindlichen Kontaktstück 16 getrennt hat, so dass nunmehr ein Stromfluss nur durch den Zähler hindurch gegeben ist.

Aufgrund der Zuordnung der Schlitze 31, 32 zu den Schlitzen 21 und 22 dergestalt, dass in der Stellung, in der die Montage beginnt, die Schlitze 31 außerhalb des durch die Schlitze 21, 22 abgedeckten Bereiches liegen, ist in diesem Zustand ein Durchgreifen durch die Schlitze 21, 22 zu den Kontaktstücken 16, 17 mit einem Gegenstand nicht möglich. Dadurch wird auch erreicht, dass bei einer anfänglichen Fehlmontage Anschlussfahnen 13 oder 14 definitiv nicht mit den Kontaktstücke 16 oder 17 in Berührung kommen, so dass durch beide Maßnahmen die Vorschrift IP 3X gewährleistet ist.

Die Kontaktstücke 16, 17 sind, in gleicher Weise wie bei der Ausführung nach der DE 10 2004 003 050, als Tulpen ausgebildet, deren Schenkel jeweils miteinander fluchten. Jeder der Schenkel ist mit einem Schlitz 40, 41 versehen, so dass zwei nebeneinanderliegende Paare von Teilschenkeln 42, 43, 44, 45 gebildet sind, wobei diese Schenkel 42 bis 45 mit den hinter der Zeichenebene und hinter der Brücke 35 liegenden Schenkel, die in der Fig. 2 nicht sichtbar sind, jeweils ein Schenkelpaar bildet. Die Länge oder Breite der Kontaktstücke 16, 17 gemessen in Richtung der Verbindungslinie der Kontaktstücke 16, 17, ist so bemessen, dass die Kontaktfahnen, wie in Fig. 3 ersichtlich ist, sofort in ihre Kontaktstücke 16, 17 eingreifen, wobei die Kontaktfahnen 13 zunächst mit den Schenkelpaaren 42 und 44 und dann mit den Schenkelpaaren 43, 45 in Kontakt gelangen. Dies hat den Vorteil, dass bei einer Schrägstellung z. B. der Kontaktstücke 16, 17 eine korrekte Kontaktierung der Kontaktfahnen 13, 14 gegeben ist.
Die Demontage erfolgt rückwärts. Aus der in Fig. 4 gezeigten Betriebsstellung wird die Platte entgegen der Pfeilrichtung P verschoben, wobei der Zapfen 33 die Brücke 35 und über die entsprechend bemassten Schlitze 31 auch den Zähler 12 mitnimmt. Dabei gleiten die Haltekrallen 20, 21 auf die Schrägfläche 37 auf und eine Kontaktierung der Kontaktfahnen 13, 14 mit den Kontaktstücken 16, 17 bleibt solange erhalten, bis die Brücke 35 das Kontaktstück 16 erreicht, so dass hier wieder ein Stromfluss über die Brücke und über den Zähler 12 erreicht wird. In der Endstellung der Demontagebewegung, die die Stellung gemäß Fig. 2 darstellt, kommen die Haltekrallen 20, 21 frei von der Trägerplatte 18, so dass der Zähler vom Adapter abgenommen werden kann.

Damit wird erreicht, dass bei der Montage und der Demontage eine gewisse Zeit der Überlappung erzielt wird, bei der der Strom sowohl über die Brücken als auch über den Zähler fließt, so dass, insbesondere beim Austausch von Zählern, eine unterbrechungsfreie Versorgung der Verbraucher gewährleistet ist.

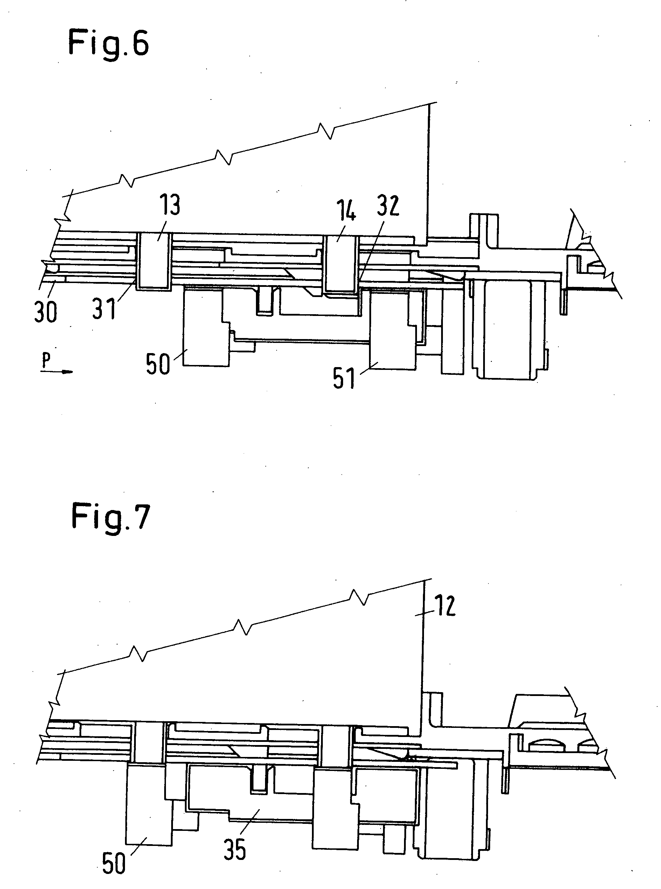

Die Ausgestaltung der Anordnung nach Figuren 5 bis 7 unterscheidet sich von der Ausführung nach den Figuren 1 bis 4 lediglich in der Ausgestaltung der Kontaktstücke, die hier die Bezugsziffern 50 und 51 aufweisen. Die Breite der Kontaktstücke 50, 51 gemessen in der Richtung der Verbindungslinie der beiden Kontaktstücke ist so bemessen, dass, wie aus Fig. 6 ersichtlich ist, dann, wenn die Kontaktfahnen 13 und 14 durch die Schlitze 31 und 32 der Trägerplatte 30 hindurchgreifen, die Anschlussfahnen 13 und 14 mit den Kontaktstücken 50 und 51 noch nicht in Berührung kommen; die Breite der Kontaktstücke 50, 51 ist etwa halb so groß wie die Breite der Kontaktstücke 16, 17. Erst im Laufe der Verschiebebewegung der Platte 30 in Pfeilrichtung P gelangen die Kontaktfahnen 13, 14 in elektrisch leitende Berührung mit den Kontaktstücken 50, 51, wobei diese elektrisch leitende Berührung schon beginnt, bevor die Brücke 35 das Kontaktstück 50 verlassen hat, so dass auch hier wieder eine gewisse Überlappungszeit ein Stromfluss über die Brücke 35 und den Zähler 12 vorhanden ist.

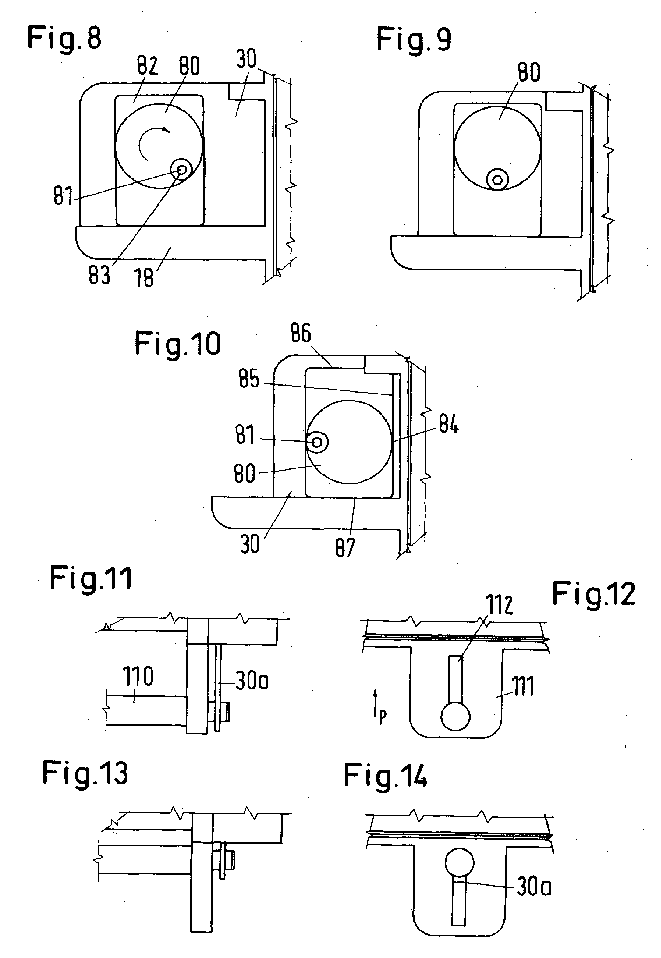

Die Betätigung der Platte kann beispielsweise auf zwei Arten erfolgen:
An der Trägerplatte 18 ist in nicht weiter dargestellter Weise ein Exzenternocken 80 an einer feststehenden Achse 81 am Adapter gelagert. Dieser Exzenternocken 80 befindet sich in einer Aussparung 82 der Platte 30. Wenn nun der Exzenternocken 80 mittels eines Werkzeuges, beispielsweise mittels eines sechskantförmigen schraubendreherartig ausgebildeten Werkzeug, welches in eine Sechskantsacklochöffnung 83 eingesteckt wird, im Uhrzeigersinn verschwenkt wird, dann gelangt der Exzenternocken, der sich um die Achse 81 dreht, in eine Mittelstellung, siehe Fig. 9 und dann in eine Endstellung siehe Fig. 10. Die Stellung gemäß Fig. 8 entspricht der Stellung gemäß den Figuren 1 und 5, und die Stellung gemäß Fig. 10 den Stellungen 4 und 7. Insbesondere in der Stellung gemäß Fig. 10, in der Berührungspunkt 84 des Exzenternockens 80 mit einer Kante 85 der Platte 30 und die Achse 81 in einer Linie liegen, kann ein unbefugtes Herausziehen des Zählers aus seiner Betriebsstellung zwecks Stromdiebstahl verhindert werden. Die Aussparung 82 ist so bemessen, dass sie eine Drehung aus der Stellung gemäß Fig. 8 in die Stellung gemäß Fig. 10 gestattet; die senkrecht zur Kante 85 verlaufenden Außenkante 86 lässt der Drehbewegung des Exzenters 80 Raum, insoweit, als der Abstand der Kante 86 von dem Mittelpunkt 81 der maximalen Exzenterweite entspricht bzw. größer ist, was für die Entfernung der Kante 87 von der Mittelachse 81 nicht gilt. Dort besteht die Möglichkeit, dass der Exzenter 80 geringfügig weiter gedreht wird, so dass die Verbindungslinie zwischen der Mittelachse und der maximalen Exzenterweite geringfügig über die Linie, die durch die durch die Mittelachse verlaufende Verschiebelinie gebildet ist, hinweggleitet und dort an die Kante anschlägt. In diesem Falle wäre eine sogenannte Übertotpunktlage erreicht, die ein Verschieben des Zählers
definitiv nicht mehr gestattet. Gegebenenfalls kann in der Stellung gemäß Fig. 10 auch eine gewisse Verrastung vorgesehen sein. Jedenfalls wird dadurch erreicht, dass ohne ein Werkzeug der Stromzähler nicht demontiert werden kann.

Anstatt eines Exzenters kann auch lediglich ein normaler handelsüblicher Schraubendreher 110 vorgesehen sein. Der Adapter besitzt eine Anformung 111, die die Schmalseitenkante überragt und in der sich ein Schlitz 112 befindet, der in Verschieberichtung des Stromzählers ausgerichtet ist. Das freie Ende des Schraubendrehers 110 durchgreift eine nicht dargestellte Öffnung in der Platte 30a und mit manueller Kraft kann der Schraubendreher 110 in Pfeilrichtung P verschoben werden, wobei das freie Ende des Schraubendrehers im Schlitz 112 läuft. Die Stellung gemäß Fig. 12 ist die Anfangsstellung und die gemäß Fig. 14 die Endstellung bzw. Betriebsstellung.

Die erfindungsgemäße Ausgestaltung ist hier anhand eines Adapters dargestellt; es besteht natürlich auch die Möglichkeit die Erfindung in identischer Weise an einem fabrikseitig hergestellten Zählerverteiler auszuführen.

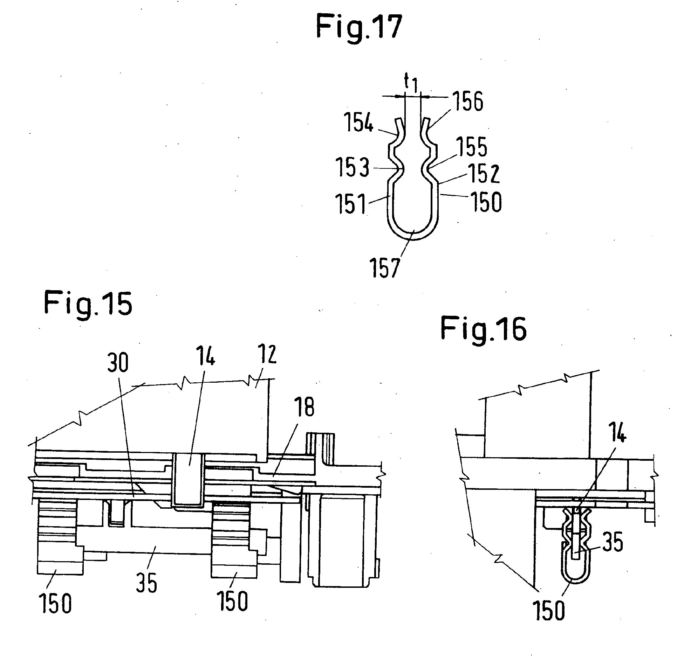

Das Kontaktstück 115 gemäß Figuren 16 und 17 besitzt eine U-Form mit zwei Schenkeln 151 und 152. Beide Schenkel besitzen zwei Einkerbungen 153 und 154 sowie 155 und 156. Der lichte Abstand t₁ der Einkerbungen 154, 155, die näher zu den freien Enden der Schenkel 151 und 152 gelegen sind, beträgt t₁ und ist damit im nicht kontaktierten Zustand kleiner als die Dicke der Kontaktfahnen 13, 14, gemessen quer oder senkrecht zur Verbindungslinie der Kontaktfahnen. Der Abstand der Einkerbungen 153 und 155 voneinander beträgt ebenfalls etwa t₁. Der Abstand t₁ ist natürlich kleiner als der Abstand der freien Abschnitte der Schenkel voneinander.

Bei der erfindungsgemäßen Ausführungsform sind die näher zum Grund 157 der U-Form gelegenen Einkerbungen 153, 155 Kontaktflächen lediglich für die Brücke 35, wogegen die Einkerbungen 154 und 156 Kontaktflächen oder Kontaktstellen lediglich mit den Kontaktfahnen 13, 14 des Zählers 12 in Kontakt gelangen.

Damit bildet die Tulpe bzw. das Kontaktstück 150 einen Hauptkontakt für die Kontaktfahnen 14, der durch die beiden Kontaktflächen der Einkerbungen 154 und 156 gebildet ist, so wie einen Hilfskontakt für die Brücke, der durch die Kontaktflächen der Einkerbungen 153, 155 gebildet sind. In diesem Falle muss auch die Dicke der Anschlussfahnen und die Dicke der Brücke, gemessen quer zur Verbindungslinie der Kontaktfahnen 13, 14 aufeinander abgestimmt sein:
Die Dicke der Kontaktfahne ist größer als die Dicke der Brücke, damit eine Kontaktierung der Fahne immer gewährleistet ist. Wäre die Brücke geringfügig dicker als die Fahne, dann könnte gegebenenfalls eine Kontaktierung des Kontaktstückes mit den Fahnen nicht gegeben sein, weil die Flächen der Einkerbungen 154, 156 durch die Brücke soweit auseinandergedrückt würden, dass eine Kontaktierung dort nicht gegeben ist.

Die Stellung des Zählers 12 bei der Darstellung gemäß Fig. 15 entspricht der Stellung des Zählers gemäß den obigen Figuren 3 und 5.

## Patentansprüche

1. Zählerplattform zum Aufsetzen eines Haushaltszählers, insbesondere eines elektronischen Haushaltszählers, mit einer Trägerplatte (18), auf die der Haushaltszähler aufgesetzt ist und durch die hindurch Kontaktfahnen (13, 14) des Haushaltszählers zu Kontaktstücken (16, 17; 50, 51; 115) sowie Haltekrallen (20, 21) in die Zählerplattform einführbar sind, wobei bei der Montage in die Betriebsstellung und aus dieser heraus die zu jeder Phase gehörenden Kontaktstücke (16, 17; 50, 51; 115) mittels einer verschiebbaren Brücke (35) verbunden und voneinander getrennt werden, **dadurch gekennzeichnet, dass** zwischen der Trägerplatte (18) und den Kontaktstücken (16, 17; 50, 51; 115) eine mit der Anzahl und Anordnung der Kontaktfahnen (13, 14) am Zähler entsprechende Anzahl und Anordnung von Schlitzen (21, 22; 31, 32; 112) versehende, nur mittels eines Werkzeuges verschiebbare Platte vorgesehen ist, an der Vorsprünge (33) angeformt sind, die in Aussparungen (34; 82) der Brücken (35) eingreifen, wobei erst nach Aufsetzen des Zählers die Platte mittels des Werkzeuges verschoben wird, so dass zunächst die Schlitze (21, 22; 31, 32; 112) in der Platte unter die Kontaktfahnen (13, 14) des Zählers und bei weiterer Verschiebung der Platte der Zähler in seine Betriebsstellung gelangen.

2. Einrichtung nach Anspruch 1, **dadurch gekennzeichnet, dass** die in Verschieberichtung der Brücken (35) gemessene Breite der Kontaktstücke (16, 17; 50, 51; 115) so bemessen ist, dass die Kontaktfahnen (13, 14) nach Einlaufen in die Schlitze (21, 22; 31, 32; 112) der Platte mit den zugehörigen Kontaktstücken (16, 17; 50, 51; 115) in elektrisch leitende Verbindung gelangen.

3. Einrichtung nach Anspruch 2, **dadurch gekennzeichnet, dass** die Kontaktstücke (16, 17; 50,51; 115) wenigstens einen Schlitz (21, 22; 31, 32; 121) aufweisen, so dass jedes Kontaktstück (16, 17; 50, 51; 115) zwei Schenkelpaare (37; 151, 152) besitzt.

4. Einrichtung nach Anspruch 1, **dadurch gekennzeichnet, dass** die Kontaktstücke (16, 17; 50, 51; 115) eine Breite, gemessen in Verschieberichtung der Brücken (35), aufweisen, die so bemessen ist, dass die Kontaktfahnen (13, 14) erst nach einer Bewegung des Zählers in Richtung Betriebsstellung in elektrisch leitende Berührung gelangen.

5. Einrichtung nach einem der vorherigen Ansprüche, **dadurch gekennzeichnet, dass** die Platte mittels eines Exzenterantriebes verschiebbar ist, der mittels eines Werkzeuges in Drehung versetzbar ist.

6. Einrichtung nach Anspruch 5, **dadurch gekennzeichnet, dass** an der Mittelachse (81) des Exzenters eine profilierte Vertiefung oder ein profilierter Zapfen (33) vorgesehen ist, mit der bzw. dem das mit entsprechender Profilierung ausgestattete Werkzeug formschlüssig in Verbindung bringbar ist.

7. Einrichtung nach einem der vorherigen Ansprüche, **dadurch gekennzeichnet, dass** in der Trägerplatte (18) ein Schlitz (112) vorgesehen ist, durch den ein Schraubendreher (110) in eine passende Ausnehmung in der Trägerplatte (30a) einführbar ist, so dass mittels des Werkzeuges die Trägerplatte (30a) manuell verschiebbar ist.

8. Einrichtung nach einem der vorherigen Ansprüche, **dadurch gekennzeichnet, dass** jeder Schenkel (151, 152) der U-förmigen Kontaktstücke (150) zwei Einkerbungen (154, 156; 153, 155) aufweist, von denen die zum freien Schenkelende hin gelegenen Einkerbungen (154, 156) Kontaktflächen ausschließlich mit den Kontaktfahnen (13, 14) des Zählers (12) (Hauptkontakte) und die Kontaktflächen der Einkerbungen (153, 155), die näher zum Grund (157) der U-Form gelegen sind, lediglich für die Brücke (35) vorgesehen sind.

9. Einrichtung nach einem der vorherigen Ansprüche, **dadurch gekennzeichnet, dass** die Dicke der Kontaktfahnen (13, 14), gemessen quer zur Verbindungslinie der Kontaktfahnen (13, 14), geringfügig größer ist als die Dicke der Brücke (35), ebenfalls gemessen zur Verbindungslinie der Kontaktfahnen (13, 14).
